**Europäisches Patentamt**

**European Patent Office**

**Office européen des brevets**

(19)

(11) Numéro de publication : **0 298 848 B1**

(12) **FASCICULE DE BREVET EUROPEEN**

(45) Date de publication du fascicule du brevet :
06.05.92 Bulletin 92/19

(51) Int. Cl.⁵ : **G06F 12/14,** H03K 3/353,
H03K 19/00, G11C 16/00,
G11C 17/00, G11C 7/00

(21) Numéro de dépôt : **88401717.9**

(22) Date de dépôt : **01.07.88**

(54) **Détecteur électrique de niveau logique binaire.**

(30) Priorité : **10.07.87 FR 8709790**

(43) Date de publication de la demande :
**11.01.89 Bulletin 89/02**

(45) Mention de la délivrance du brevet :
**06.05.92 Bulletin 92/19**

(84) Etats contractants désignés :
**DE ES GB IT NL**

(56) Documents cités :
**EP-A- 0 044 066**
**EP-A- 0 130 587**
**EP-A- 0 169 941**
**US-A- 4 563 595**

(73) Titulaire : **SGS-THOMSON**
**MICROELECTRONICS S.A.**
**7, Avenue Galliéni**
**F-94250 Gentilly (FR)**

(72) Inventeur : **Kowalski, Jacek**
**50 Lotissement les Jardins des Seignières**
**F-13530 Trets (FR)**

(74) Mandataire : **Schmit, Christian Norbert Marie**
**et al**
**Cabinet Ballot-Schmit 7, rue Le Sueur**
**F-75116 Paris (FR)**

## Description

La présente invention a pour objet un détecteur électrique de niveau logique binaire. Elle trouve son application dans le domaine de l'informatique et, dans celui-ci, plus particulièrement dans le domaine des cartes à mémoire munies de microprocesseurs et de circuits mémoire en technologie M O S du type non volatile (EPROM ou EEPROM). Elle concerne également les amplificateurs de lecture d'informations contenues dans des mémoires électroniques du type dynamique ou statique à accès aléatoire.

L'utilisation des cartes à mémoire connaît une croissance importante. L'utilisation la plus complète concerne le domaine bancaire où des cartes à mémoire à circuit intégré incorporé sont destinées à terme à remplacer les carnets de chèques et à servir de moyen universel de transaction entre les divers opérateurs économiques. Quelles que soient les opérations financières exécutées avec une telle carte, celle-ci doit contenir deux types d'informations. Un premier type d'informations concerne les soldes bancaires : ces informations rendent compte de la hauteur du solde avant et après chaque opération. Ces informations de solde doivent être accessibles à l'utilisateur. Elles ont un caractère confidentiel mais demandent cependant à être connues. D'autres informations par contre doivent rester secrètes. Certaines doivent rester secrètes sauf pour le titulaire de la carte : il s'agit dans ce cas de son code secret de validation d'une opération exécutée avec cette carte. D'autres doivent rester secrètes à l'égard de qui que ce soit y compris le titulaire de la carte : ce sont en général des informations utilisées pour l'élaboration du code secret qui, en dehors du titulaire, n'est pas connu et qui ne peut donc être reconstitué par manipulations électriques de la carte. Malheureusement, l'imagination des fraudeurs n'a pas de limite, et il est nécéssaires de se prémunir de toutes tentatives de décryptage des informations secrètes contenues dans les cartes.

On s'est ainsi rendu compte qu'un fraudeur avisé pouvait tenter de mesurer la consommation électrique d'un circuit de polarisation du système de lecture des informations contenues dans une carte pour déterminer, par mesure de la variation de consommation électrique, l'allure des niveaux logiques débités par la carte de manière à en déduire les codes secrets y inscrits. En effet, les points mémoire des cartes à mémoire en circuit intégré sont souvent du type comportant un transistor à deux grilles : une grille de commande et une grille flottante. Des charges piégées dans la grille flottante peuvent s'opposer à la mise en conduction du transistor en réponse à une commande appliquée sur la grille de commande et révéler ainsi leur présence, tandis que leur absence rendrait le transistor conducteur et provoquerait dans un circuit de mesure en série avec ce transistor une variation du signal qui lui est introduit. La programmation d'une telle mémoire s'effectue donc en piégeant ou en ne piégeant pas de telles charges dans les grilles flottantes de ces transistors. Cependant, d'une situation à l'autre, l'énergie électrique ainsi mise en jeu est faible. Et l'information demande pour pouvoir être transmise correctement jusqu'à un organe de lecture, ou à un organe d'exécution d'une transaction financière, à être amplifiée.

En pratique on réalise simplement ces amplificateurs, en technologie CMOS en utilisant deux transistors de conductivité inverse, un de type P et un de type N, en série et polarisés entre la tension Vcc d'alimentation du circuit et la masse. Les grilles de ces transistors sont réunies ensemble et reçoivent le signal à amplifier. La sortie est prélevée sur le point milieu de ces transistors. Ce montage amplificateur est inverseur. L'inconvénient d'un tel inverseur utilisé comme amplificateur est qu'il présente une différence de consommation importante selon qu'il doit transmettre un état logique 1 ou un état logique O. Et le courant qui traverse cet amplificateur révèle ainsi par sa valeur l'état logique lu. En effet, quand il consomme un courant plus important, l'impédance interne du générateur de polarisation donne lieu à une chute de tension de l'alimentation qui peut être exploitée dans ce sens. Quels que soient les perfectionnements apportés à ces générateurs, les circuits de connexion de cette alimentation aux cartes étant des circuits à contacts, donc forcément résistifs, ils jouent le rôle d'une telle résistance interne et provoquent la chute de tension révélatrice.

Une solution décrite dans la demande européenne EP-A-279 712, cité selon Art. 54(3) (BE) est spécifiée dans le préambule de la revendication 1, 2, 3 et 4. Dans l'invention, on propose des perfectionnements.

En effet, dans les circuits mémoire de type dynamique l'information de niveau logique à détecter est transitoire. La détection d'un niveau logique donné peut être d'autant mieux assurée qu'on peut transformer cette information fugitive en une information maintenue, au moins un certain temps. De plus il est nécéssaire qu'un tel détecteur, en dehors des instants où il est chargé d'effectuer sa détection, présente une consommation statique la plus faible possible. En effet il est nécéssaire de ne pas trop élever la température du circuit intégré dont ce détecteur pourrait faire partie. Enfin le détecteur ainsi réalisé doit être un détecteur rapide : il doit avoir une vitesse de fonctionnement aussi élevée que celle d'une porte logique.

L'invention a pour objet de donner une solution à ces problèmes en proposant un détecteur muni essentiellement de deux circuits de détection branchés en parallèle entre l'alimentation électrique et la masse et complémentaires l'un de l'autre. Selon le niveau logique introduit un des deux circuits bascule et entraîne une consommation électrique équivalente à la consommation électrique entraînée par l'autre circuit quand ce dernier bascule pour un niveau logique binaire différent. Judicieusement, pour éviter des consommations électriques intempestives en dehors des périodes de détection ces deux circuits sont activés puis désactivés au moment de la réception de chaque niveau logique détecté. Le signal de désactivation ultérieur au signal d'activation du détecteur peut même être utilisé pour remettre à zéro le détecteur et le rendre disponible pour une détection suivante.

L'invention concerne donc :

– un détecteur électrique de niveau logique binaire, comportant un premier et un second circuit en parallèle qui reçoivent un même signal à détecter, ces deux circuits ayant des consommations électriques complémentaires de manière à avoir toujours la même consommation totale du détecteur, que l'on détecte un niveau logique binaire "0" ou que l'on détecte un niveau logique binaire "1", caractérisé en ce que chaque circuit comporte une commande d'activation pour être activé quand un niveau est à détecter et pour être désactivé en dehors de ces périodes, la commande de désactivation servant de remise à zéro du détecteur.

– un détecteur électrique de niveau logique binaire, comportant un premier et un second circuit en parallèle qui reçoivent un même signal à détecter, ces deux circuits ayant des consommations électriques complémentaires de manière à avoir toujours la même consommation totale du détecteur, que l'on détecte un niveau logique binaire "0" ou que l'on détecte un niveau logique binaire "1", caractérisé en ce qu'il comporte un circuit de maintien du niveau logique délivré pour améliorer la détection de niveaux logiques reçus transitoires.

– un détecteur électrique de niveau logique binaire, comportant un premier et un second circuit en parallèle qui reçoivent un même signal à détecter, ces deux circuits ayant des consommations électriques complémentaires de manière à avoir toujours la même consommation totale du détecteur, que l'on détecte un niveau logique binaire "0" ou que l'on détecte un niveau logique binaire "1", caractérisé en ce que les deux circuits comportent des moyens pour être couplés et se maintenir mutuellement dans leurs états respectifs.

– un détecteur électrique de niveau logique binaire, comportant un premier et un second circuit en parallèle qui reçoivent un même signal à détecter, ces deux circuits ayant des consommations électriques complémentaires de manière à avoir toujours la même consommation totale du détecteur, que l'on détecte un niveau logique binaire "0" ou que l'on détecte un niveau logique binaire "1", caractérisé en ce que chaque circuit comporte en série entre Vcc et une borne délivrant un signal inverse de précharge, un premier transistor de type P, un second transistor de type P et un troisième transistor de type N, les premiers transistors ayant leur grille reliée à un signal de précharge, la sortie du premier et du second circuit respectivement étant prise au point milieu entre le premier et le second transistor, les grilles des second et troisième transistors du premier circuit étant respectivement reliées au signal à détecter et à Vcc, les grilles du second et troisième transistor du second circuit étant respectivement reliées à la masse et au signal à détecter.

L'invention sera mieux comprise à la lecture de la description qui suit et l'examen des figures qui l'accompagnent. Celles-ci ne sont données qu'à titre indicatif et nullement limitatif de l'invention. Les figures montrent :

– figure 1 : une représentation schématique d'un détecteur selon l'invention ;

– figure 2 : des diagrammes temporels de signaux de synchronisation intervenant dans le dispositif de l'invention.

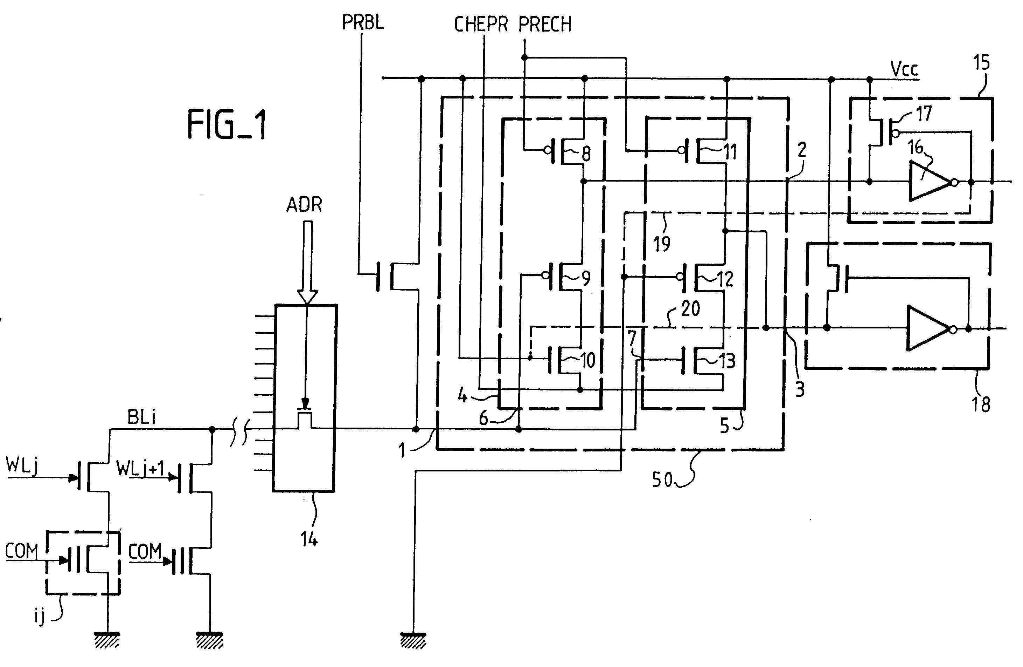

La figure 1 montre un détecteur électrique 50 de niveau logique binaire conforme à l'invention. Celui-ci comporte une entrée 1 pour recevoir un signal d'un niveau logique donné et, dans l'exemple représenté, deux sorties 2 et 3 pour délivrer au moins un signal d'un niveau logique correspondant au niveau logique reçu. Ici les deux signaux délivrés sont même complémentaires l'un de l'autre. Dans sa caractéristique essentielle le détecteur de l'invention comporte des moyens pour rendre sa consommation indépendante des niveaux logiques délivrés. Dans la solution particulière représentée les moyens pour rendre la consommation indépendante des niveaux logiques délivrés comportent essentiellement deux circuits, 4 et 5, polarisés à Vcc, en parallèle l'un de l'autre, et recevant tous deux par une entrée respectivement 6 et 7 le signal à détecter.

Les deux circuits 4 et 5 présentent la particularité de posséder des consommations électriques complémentaires vis à vis des niveaux logiques binaires à détecter. Dans l'exemple particulier et préféré représenté, les deux circuits 4 et 5 sont même totalement identiques ce qui assure la complémentarité de la consommation électrique. Ils ne sont différenciés que par le mode de connexion des composants qu'ils comportent.

Ainsi, le circuit 4 comporte trois transistors en série, respectivement les transistors 8 à 10, tandis que le circuit 5 comporte trois autres transistors en série, les transistors 11 à 13. Les transistors 8, 9, 11 et 12, sont des transistors à canal P (leur grille est munie symboliquement d'un petit rond). Ils possèdent la particularité, en étant alimentés par une tension Vcc positive, d'être conducteurs quand ils reçoivent un niveau électrique nul (la masse) sur leur grille, et d'être au contraire bloqués lorsqu'ils y reçoivent un niveau électrique un (Vcc). Les transistors 10 et 13 sont des transistors à canal N : leur fonctionnement est inverse des précédents. Dans les circuits 4 et 5 les trois transistors sont montés en série entre le potentiel d'alimentation Vcc et une borne commune recevant un signal CHEPR complémentaire d'un signal PRECH qui est, lui, appliqué sur les grilles des transistors 8 et 11. Dans un exemple particulier de réalisation la grille du transistor 10 est reliée au potentiel d'alimentation Vcc tandis que la grille du transistor 12 est reliée à la masse. Les grilles des transistors restants 9 et 13 sont reliées ensemble à l'entrée 1 du détecteur. La sortie 2 du détecteur est prélevée au point milieu des transistors 8 et 9 tandis que la sortie 3 est prélevée au point milieu des transistors 11 et 12.

Le signal PRECH est un signal de pré-charge ; il est complémentaire du signal CHEPR et il est en général nul tandis que ce dernier vaut Vcc. Au moment de la détection, après qu'un signal de pré-charge de ligne de bits PRBL d'une mémoire (par exemple portée par une carte à mémoire) a été appliqué à la sortie d'un décodeur 14, en fonction d'un signal d'adresse ADR une ligne de bits de rang "i" BLi est sélectionnée. La sélection simultanée d'une ligne de mots permet alors à une ligne de mots particulière WLj d'adresser au décodeur 14 l'information contenue dans un point mémoire "ij". Cette information est envoyée au détecteur. La variation du courant d'alimentation se produit dans plusieurs lignes de mots, en même temps, de sorte que son exploitation en vue de son décodage frauduleux devient impossible. Ultérieurement lorsque le détecteur reçoit l'ordre de validation de détection, il bascule de manière différente selon la nature de l'information disponible à son entrée 1.

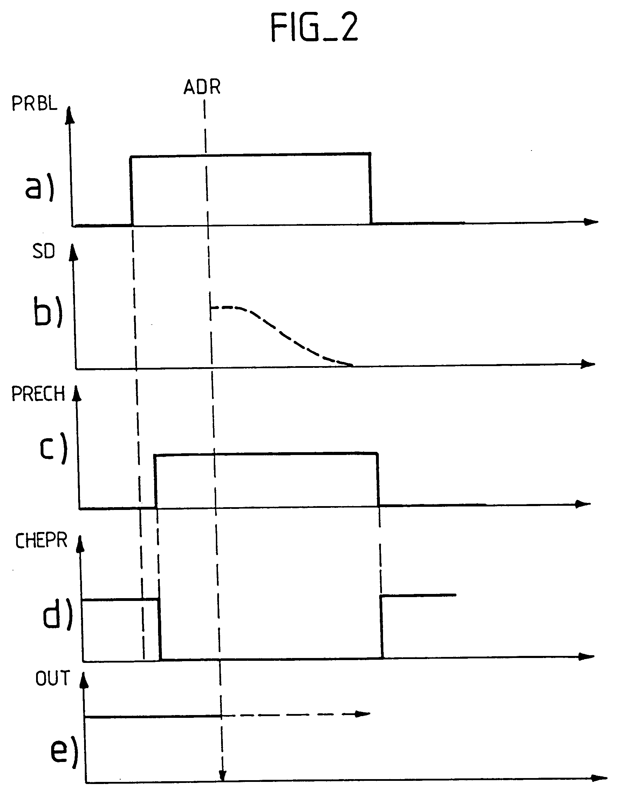

Avant l'apparition du signal SD à détecter le signal de pré-charge PRECH vaut zéro et le signal CHEPR vaut Vcc (figure 2). Dans ce cas les deux signaux S2 et S3 disponibles aux sorties 2 et 3 valent Vcc. En effet les transistors 8 et 11 conduisent puisque , étant du canal P, ils reçoivent un potentiel nul sur leur grille : la tension Vcc est donc transmise aux sorties 2 et 3. Tous les transistors 8 à 12 sont alors conducteurs, seul le transistor 13 est bloqué. Après l'application du signal PRBL, qui précharge l'entrée du détecteur et les lignes de bits à un, la lecture de la cellule a lieu. Le signal SD reste soit à un, soit se décharge à zéro. Une fois le niveau stabilisé, le signal PRECH bascule à Vcc et CHEPR à zéro. Dans un premier cas le signal SD disponible à l'entrée 1 vaut zéro. Dans ce cas le transistor 13 reste bloqué tandis que le transistor 9 devient conducteur. Le transistor 8 se bloque et le transistor 10 devient conducteur. Dans ces conditions la sortie 2 passe à l'état zéro. Par contre, le blocage de transistor 11, la mise en conduction du transistor 12 et le blocage du transistor 13 maintiennent la sortie 3 au niveau un. A l'opposé, si le signal émis en entrée est d'un niveau un et vaut Vcc, les transistors 12 et 13 se mettent à conduire et la sortie 3 bascule à zéro tandis que la sortie 2 reste à Vcc.

Quelle que soit la situation les transistors 10 et 12 conduisent toujours. Leur rôle est uniquement de rendre symétrique les deux branches identiques. De cette manière on obtient des vitesses de décharge identiques dans les deux branches. On ne peut de ce fait pas non plus utiliser la vitesse de décharge, par son retentissement sur le circuit d'alimentation, comme information susceptible de révéler les niveaux logiques transmis. A l'issue de la transmission le signal PRECH retombe à zéro et le signal CHEPR varie complémentairement. Le détecteur reprend alors son état initial : transistors 8, 9 10, 11 et 12 conducteurs, transistor 13 bloqué, les deux sorties 2 et 3 à l'état Vcc. Dans cet état le détecteur ne consomme aucun courant puisque les transistors conducteurs sont raccordés de part et d'autre à des potentiels égaux et puisque l' autre transistor est bloqué.

Lorsque le détecteur détecte, au moment du basculement, une des deux sorties 2 ou 3 reste à l'état Vcc tandis que l'autre retourne à zéro. Celle qui reste à l'état Vcc est en fait dans un état instable à ce potentiel. En effet ce potentiel est prélevé entre deux transistors bloqués en série : transistors 8 et 9 quand un état zéro est disponible à l'entrée 1, transistors 11 et 12 quand un état Vcc est disponible à l'entrée 1. Pour maintenir les sorties 2 et 3 à ce niveau significatif on utilise, en série avec chacune des deux sorties, un circuit bistable tel par exemple que le circuit 15. Le circuit 15 comporte essentiellement un inverseur 16 en série avec la sortie 2 et un transistor à canal P 17 branché en parallèle entre l'alimentation Vcc et l'entrée de l'inverseur 16. La sortie de l'inverseur 16 est rebouclée sur la grille du transistor 17. Si un état un (Vcc) est disponible à l'entrée de l'inverseur 16, à sa sortie un état zéro est disponible. Dans ces conditions le transistor 17 devient conducteur et transmet, en maintenant le potentiel, la tension Vcc à l'entrée de l'inverseur 16. Par contre si le potentiel à la sortie 2 est nul la sortie de l'inverseur 16 est portée à Vcc, ce qui bloque le transistor 17, et ce qui maintient effectivement l'entrée de l'inverseur 16 à zéro.

Dans une variante préférée de réalisation, les deux circuits 4 et 5 sont même couplés l'un à l'autre par l'intermédiaire de leurs circuits bistables respectifs 15 et 18. Dans ce but la sortie du circuit 15, c'est à dire la sortie de l'inverseur 16, est reliée par une connexion 19 à la grille du transistor 12, et la connexion à la masse de cette grille du transistor 12 est coupée. Dans le même but l'entrée du bistable 18, c'est à dire en définitive la sortie 3 du détecteur, est reliée par une connexion 20 à la grille du transistor 10, et la connexion à l'alimentation Vcc de la grille du transistor 10 est coupée. Ces deux dernières liaisons sont montrées en tirets sur la figure 1. Ce type de connexion constitue pour l'ensemble du détecteur un montage stable à trois états. En dehors des périodes de détection, les sorties 2 et 3 sont à Vcc, la sortie du bistable 15 est donc à zéro et les nouvelles connexions 19 et 20 maintiennent les grilles des transistors respectivement 12 et 10 dans les mêmes états que décrits jusqu'à présent. Lors d'une détection l'une des deux sorties est portée à Vcc alors que l'autre est portée à zéro. Lorsque la sortie 2 est portée seule à Vcc (un niveau logique un est disponible à l'entrée 1) le transistor 12 reçoit un potentiel nul : rien n'est changé pour lui. Par contre le transistor 10 reçoit également un potentiel nul et il a donc tendance à se bloquer également. Il en résulte que si un parasite intervient tendant à faire passer l'entrée 1 à un niveau zéro (par exemple un écroulement de la tension délivrée par la mémoire) le transistor 9 pourra se mettre en conduction sans altérer le niveau du potentiel disponible sur la sortie 2 puisque le blocage du transistor 10 vient assurer la valeur de ce potentiel en sortie 2 à Vcc.

Dans l'autre cas quand un niveau logique zéro est à détecter à l'entrée du détecteur, la sortie 3 est portée à une potentiel Vcc tandis que la sortie 2 est portée à zéro. Il en résulte que le transistor 10 reçoit sur sa grille une tension Vcc : rien n'est changé pour lui par rapport à son schéma de connexion antérieur. Par contre le transistor 12 reçoit maintenant sur sa grille un signal polarisé à Vcc. Comme le transistor 12 est un transistor à canal P il se bloque. En conséquence la sortie 3 prise entre deux transistors bloqués, les transistors 11 et 12, reste à son potentiel : au potentiel Vcc. Elle y reste même si un parasite se produit. Lorsque les signaux de pré-charge PRECH et CHEPR reprennent leur valeur d'attente, les sorties des circuits 15 et 18 retombent toutes à zéro.

Le mode de connexion ainsi réalisée présente donc l'avantage d'avoir trois états stables, un état stable d'attente de détection, et deux états stables dépendant du niveau logique détecté. Dans les deux états stables dépendant du niveau logique détecté, le circuit est capable de prendre en compte les phénomènes transitoires et de maintenir l'information quels que soient les aléas subis ultérieurement par les informations à détecter. En particulier ce mode de fonctionnement est particulièrement intéressant quand, avant de lire d'autres cellules mémoire, on prend la précaution de décharger les lignes de mots WLj avec une tension Vss (négative) après une précédente lecture. Cette précaution qui améliore la fiabilité de la lecture de l'information contenue dans une cellule mémoire était jusqu'à présent gênante pour la prise en compte des informations lues. Par ailleurs, les bistables 15 et 18 étant complémentaires la consommation est la même quel que soit le niveau logique détecté.

Dans les circuits logiques situés en aval on peut exploiter un des signaux délivrés par les bistables, ou même les deux. Dans ces circuits logiques en aval, le traitement subi par les signaux rend leur décodage frauduleux impossible. D'une manière préférée un détecteur selon l'invention est incorporé dans le circuit intégré porté par une carte à mémoire. Il est peu encombrant, sa réalisation n'entraîne pas de phases particulières de fabrication de ce circuit intégré. Un seul détecteur est utilisé pour une carte.

**Revendications**

1. Détecteur électrique (50) de niveau logique binaire, comportant un premier et un second circuit (4, 5) en parallèle qui reçoivent un même signal à détecter (1), ces deux circuits (4,5) ayant des consommations électriques complémentaires de manière à avoir toujours la même consommation totale du détecteur (50), que l'on détecte un niveau logique binaire "0" ou que l'on détecte un niveau logique binaire "1", caractérisé en ce que chaque circuit comporte une commande d'activation (PRECH, CHEPR) pour être activé quand un niveau est à détecter et pour être désactivé en dehors de ces périodes, la commande de désactivation servant de remise à zéro du détecteur.

2. Détecteur électrique (50) de niveau logique binaire, comportant un premier et un second circuit (4, 5) en parallèle qui reçoivent un même signal à détecter (1), ces deux circuits (4,5) ayant des consommations électriques complémentaires de manière à avoir toujours la même consommation totale du détecteur (50), que l'on détecte un niveau logique binaire "0" ou que l'on détecte un niveau logique binaire "1", caractérisé en ce qu'il comporte un circuit (15, 18) de maintien du niveau logique délivré pour améliorer la détection de niveaux logiques reçus transitoires.

3. Détecteur électrique (50) de niveau logique binaire, comportant un premier et un second circuit (4, 5) en parallèle qui reçoivent un même signal à détecter (1) ces deux circuits (4,5) ayant des consommations électriques complémentaires de manière à avoir toujours la même consommation totale du détecteur (50), que l'on détecte un niveau logique binaire "0" ou que l'on détecte un niveau logique binaire "1", caractérisé en ce que les deux circuits comportent des moyens (19, 20) pour être couplés et se maintenir mutuellement dans leurs états respectifs.

4. Détecteur électrique (50) de niveau logique binaire, comportant un premier et un second circuit (4, 5) en parallèle qui reçoivent un même signal à détecter (1) ces deux circuits (4,5) ayant des consommations électriques complémentaires de manière à avoir toujours la même consommation totale du détecteur (50), que l'on détecte un niveau logique binaire "0" ou que l'on détecte un niveau logique binaire "1", caractérisé en ce que chaque circuit comporte en série entre Vcc et une borne délivrant un signal inverse de précharge (CHEPR), un premier transistor de type P, un second transistor de type P et un troisième transistor de type N, les premiers transistors ayant leur grille reliée à un signal de précharge (PRECH), la sortie (2, 3) du premier et du second circuit respectivement (4, 5) étant prise au point milieu entre le premier et le second transistor, les grilles des second et troisième transistors du premier circuit étant respectivement reliées au signal à détecter (1) et à Vcc, les grilles du second et troisième transistor du second circuit (5) étant respectivement reliées à la masse et au signal à détecter (1).

5. Utilisation d'un détecteur selon l'une quelconque des revendications 1 à 4 comme amplificateur de lecture dans un système de lecture des informations contenues dans un circuit mémoire d'une carte mémoire du type comportant une mémoire en circuit intégré.

6. Utilisation selon la revendication 5 caractérisée en ce que le détecteur fait partie intégrante des circuits intégrés dans la carte mémoire.

**Patentansprüche**

1. Elektrischer Detektor (50) für einen binären logischen Pegel, mit einer ersten und einer zweiten Schaltung (4, 5), die parallel geschaltet sind und dasselbe zu erfassende Signal empfangen, wobei diese zwei Schaltungen (4, 5) komplementäre elektrische Verbräuche besitzen, derart, daß sie bei Erfassung eines binären logischen Pegels "0" oder bei Erfassung eines binären logischen Pegels "1" stets denselben Gesamtverbrauch des Detektors (50) ergeben, dadurch gekennzeichnet, daß jede Schaltung einen Aktivierungsbefehl (PRECH, CHEPR) enthält, um aktiviert zu werden, wenn ein Pegel erfaßt werden soll, und um außerhalb dieser Perioden inaktiv gemacht zu werden, wobei der Inaktivierungsbefehl dem Rücksetzen auf Null des Detektors dient.

2. Elektrischer Detektor (50) für einen binären logischen Pegel, mit einer ersten und einer zweiten Schaltung (4, 5), die parallel geschaltet sind und dasselbe zu erfassende Signal empfangen, wobei diese Schaltungen (4, 5) komplementäre elektrische Verbräuche besitzen, derart, daß sie bei Erfassung eines binären logischen Pegels "0" oder bei Erfassung eines binären logischen Pegels "1" stets denselben Gesamtverbrauch des Detektors (50) ergeben, dadurch gekennzeichnet, daß er eine Schaltung (15, 18) zum Halten des gelieferten logischen Pegels aufweist, um die Erfassung der momentan empfangenen logischen Pegel zu verbessern.

3. Elektrischer Detektor (50) für einen binären logischen Pegel, mit einer ersten und einer zweiten Schaltung (4, 5), die parallel geschaltet sind und dasselbe zu erfassende Signal empfangen, wobei diese Schaltungen (4, 5) komplementäre elektrische Verbräuche besitzen, derart, daß sie bei Erfassung eines binären logischen Pegels "0" oder bei Erfassung eines binären logischen Pegels "1" stets denselben Gesamtverbrauch des Detektors (50) ergeben, dadurch gekennzeichnet, daß die zwei Schaltungen Mittel (19, 20) aufweisen, um miteinander verbunden zu werden und sich gegenseitig in den jeweiligen Zuständen zu halten.

4. Elektrischer Detektor (50) für einen binären logischen Pegel, mit einer ersten und einer zweiten Schaltung (4, 5), die parallel geschaltet sind und dasselbe zu erfassende Signal empfangen, wobei diese Schaltungen (4, 5) komplementäre elektrische Verbräuche besitzen, derart, daß sie bei Erfassung eines binären logischen Pegels "0" oder bei Erfassung eines binären logischen Pegels "1" stets denselben Gesamtverbrauch des Detektors (50) ergeben, dadurch gekennzeichnet, daß jede Schaltung zwischen Vcc und einem ein inverses Vorladungssignal (CHEPR) liefernden Anschluß eine einen ersten Transistor vom P-Typ, einen zweiten Transistor vom P-Typ und einen dritten Transistor vom N-Typ umfassende Reihenschaltung aufweist, wobei die ersten Transistoren mit ihrem Gate mit einem Vorladungssignal (PRECH) verbunden sind, wobei die Ausgaben (2, 3) der ersten bzw. der zweiten Schaltung (4, 5) in der Mitte zwischen dem ersten und dem zweiten Transistor abgegriffen werden, wobei die Gates des zweiten und des dritten Transistors der ersten Schaltung mit dem zu erfassenden Signal (1) bzw. mit Vcc verbunden sind und wobei die Gates des zweiten und des dritten Transistors der zweiten Schaltung (5) mit Masse bzw. mit dem zu erfassenden Signal (1) verbunden sind.

5. Verwendung eines Detektors gemäß einem der Ansprüche 1 bis 4 als Leseverstärker in einem System zum Lesen von Informationen, die in einer Speicherschaltung einer Speicherkarte enthalten sind, wobei die Speicherkarte von einem Typ ist, der einen Speicher in Form einer integrierten Schaltung aufweist.

6. Verwendung gemäß Anspruch 5, dadurch gekennzeichnet, daß der Detektor einen integrierten Teil der integrierten Schaltungen in der Speicherkarte bildet.

**Claims**

1. A binary logic level electrical detector (50) comprising a first and a second circuit (4 and 5) arranged in parallel which receive the same signal to be detected, these two circuits (4 and 5) having a complementary electrical consumption in such a manner as to always have the same total consumption of the detector (50), for detecting a binary logic level "0" or a binary logic level " 1 ", characterized in that each circuit comprises an activating command (PRECH and CHEPR) in order to be activated when a level is to be detected and to be de-activated outside of these periods, the de-activating command functioning to reset the detector at zero.

2. A binary logic level electrical detector (50) comprising a first and a second circuit (4 and 5) arranged in parallel which receive the same signal to be detected, these two circuits (4 and 5) having a complementary electrical consumption in such a manner as to always have the same total consumption of the detector (50), for detecting a binary logic level "0" or a binary logic level " 1 ", characterized in that it comprises a hold circuit (15 and 18) to hold the supplied logic level in order to improve the detection of transient logic levels received.

3. A binary logic level electrical detector (50) comprising a first and a second circuit (4 and 5) arranged in parallel which receive the same signal to be detected, these two circuits (4 and 5) having a complementary electrical consumption in such a manner as to always have the same total consumption of the detector (50) for detecting a binary logic level of "0" or a " 1 " binary logic level, characterized in that the two circuits comprise means (19 and 20) in order to be coupled and to mutually maintain themselves in their respective states.

4. A binary logic level electrical detector (50) comprising a first and a second circuit (4 and 5) arranged in parallel which receive the same signal to be detected, these two circuits (4 and 5) having a complementary electrical consumption in such a manner as to always have the same total consumption of the detector (50) for detecting a binary logic level of "0" or a " 1 " binary logic level, characterized in that between Vcc and a terminal supplying an inverse bias signal (CHEPR) each circuit comprises in series a first P type transistor, a second P type transistor and a third N type transistor, the first transistors having their gate connected with a bias signal (PRECH), the outputs (2 and 3) of the first (4, 5) and of the second transistors being taken at the center point between the first and the second transistor, the gates of the second and the third transistors of the first circuit being respectively connected with the signal (1) to be detected and with Vcc, the gates of the second and of the third transistors of the second circuit (5) being respectively connected with ground and with the signal to be detected (1).

5. The use of a detector as claimed in any one of the preceding claims 1 through 4 as a read amplifier in a read system for information contained in a memory circuit of a memory board of the type comprising an integrated circuit memory.

6. The use as claimed in claim 5, characterized in that the detector constitutes an integrating part of the integrated circuits in the memory board.

FIG_1

# FIG_2